(19) Europäisches Patentamt / European Patent Office / Office européen des brevets

(11) **EP 4 572 114 A1**

(12) **EUROPEAN PATENT APPLICATION**

(43) Date of publication:
**18.06.2025** Bulletin 2025/25

(21) Application number: **24219076.7**

(22) Date of filing: **11.12.2024**

(51) International Patent Classification (IPC):
**H02M 3/335** (2006.01)    **G01R 33/02** (2006.01)
**H02M 1/00** (2006.01)

(52) Cooperative Patent Classification (CPC):
**H02M 3/33592; G01R 33/02; H02M 1/0009;
H02M 3/33507**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.12.2023   US 202363610775 P
22.11.2024   US 202418957255**

(71) Applicant: **Power Integrations, Inc.
San Jose, CA 95138 (US)**

(72) Inventors:
• **Armamento, Michael Joseph Baylon
San Jose, 95148 (US)**
• **Bautista, Marvin Ralph  B.
San Jose, 95119 (US)**
• **Orcullo, Norberto
Renton, 98056 (US)**

(74) Representative: **Fish & Richardson P.C.
Highlight Business Towers
Mies-van-der-Rohe-Straße 8
80807 München (DE)**

(54) **A FLUX DETECTION CIRCUIT AND METHOD THEREIN FOR SENSING MAGNETIC FLUX VIA A MAGNETIC FLUX PROBE**

(57)     Presented herein are a flux detection circuit for sensing magnetic flux via a magnetic flux probe and method therein. A magnetic flux probe comprising circuit elements and forming a loop around a magnetic core avails interconnection of a flux-sensitive trace across a winding window. The flux detection circuit is configured to measure an electromotive force (emf) of one or more elements of the loop; and at least one of the circuit elements may be adjustable (e.g., may comprise a variable resistance). In this manner the magnetic flux probe and flux detection circuit may be calibrated to accurately detect a signal proportional to the time-varying magnetic flux and to provide the signal across a winding window.

FIG. 1B

EP 4 572 114 A1

**Description**

CROSS-REFERENCE TO RELATED APPLICATIONS

This application claims priority from U.S. Provisional Application No. 63/610,775 filed on December 15, 2023 and from U.S. Patent Application No. 18/957,255 filed on November 22, 2024, hereby incorporated by reference in its entirety.

FIELD OF THE DISCLOSURE

The present invention relates to a circuit approach for sensing time varying magnetic fields by exploiting Faraday's Law.

BACKGROUND INFORMATION

Many electronic devices, such as mobile phones, laptop computers, etc., are powered by direct current (dc) power derived from a power supply. Conventional wall outlets generally deliver a high voltage alternating current (ac) power that needs to be converted to regulated dc power in order to be used as a power source for consumer electronic devices. Switch mode converters, also referred to as switching power supplies, are commonly used due to their high efficiency, small size, and low weight to convert a high voltage ac power to a regulated dc power.

Switching power supplies may also include magnetic circuits to transfer energy. Magnetic circuits are analogous to electric circuits. For instance, a magnetic circuit provides a path for magnetic flux; and an applied magnetomotive force, analogous to an electromotive force, forces magnetic flux along the magnetic circuit path.

BRIEF DESCRIPTION OF THE DRAWINGS

Non-limiting and non-exhaustive embodiments of flux detection circuits for sensing magnetic flux are described with reference to the following figures, wherein like reference numerals refer to like parts throughout the various views unless otherwise specified.

**FIG. 1A** illustrates a magnetic flux probe according to an embodiment.
**FIG. 1B** illustrates a magnetic flux probe according to another embodiment.
**FIG. 2A** illustrates a top-perspective view of a magnetic core and interconnect routing for receiving a probe signal according to an embodiment.
**FIG. 2B** illustrates a top-perspective view of a magnetic core and interconnect routing for receiving a probe signal according to another embodiment.
**FIG. 2C** illustrates a top-perspective view of a magnetic core and interconnect routing for receiving one or more probe signals according to an embodiment.
**FIG. 2D** illustrates a top-perspective view of a magnetic core and interconnect routing for receiving one or more probe signals according to another embodiment.
**FIG. 3A** illustrates a schematic including a magnetic flux probe according to an embodiment.
**FIG. 3B** illustrates a schematic including a magnetic flux probe according to another embodiment.
**FIG. 4A** illustrates a schematic of a flyback converter according to an embodiment.
**FIG. 4B** illustrates a schematic of a flyback converter according to another embodiment.
**FIG. 4C** illustrates a schematic of a flyback converter according to another embodiment.
**FIG. 4D** illustrates a schematic of a flyback converter according to another embodiment.
**FIG. 5A** illustrates a three-dimensional (3D) top view perspective of a flyback converter according to a printed circuit board (PCB) embodiment.
**FIG. 5B** illustrates a three-dimensional (3D) top view perspective of a flyback converter according to the embodiment of FIG. 5A.
**FIG. 5C** illustrates a three-dimensional (3D) top view perspective of a flyback converter according to the embodiment of FIG. 5A.
**FIG. 6A** illustrates interconnect routing of a magnetic flux probe and interconnect routing according to the embodiment of FIG. 5A.
**FIG. 6B** illustrates interconnect routing of a magnetic flux probe and interconnect routing according to another embodiment.
**FIG.7A** illustrates a schematic diagram of a flyback converter according to the embodiment of FIG. 6A.
**FIG. 7B** illustrates a schematic diagram of a flyback converter according to the embodiment of FIG. 6A.
**FIG. 8A** illustrates waveforms according to the teachings herein.

EP 4 572 114 A1

**FIG. 8B** illustrates waveforms according to the teachings herein.

**FIG. 9** illustrates a conceptual flow diagram for controlling a synchronous rectifier during a switching cycle.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the teachings herein. Also, common but well-understood elements that are useful or necessary in a commercially feasible embodiment are often not depicted in order to facilitate a less obstructed view of these various embodiments of flux detection circuits.

DETAILED DESCRIPTION

In the following description, numerous specific details are set forth in order to provide a thorough understanding of flux detection circuits. It will be apparent, however, to one having ordinary skill in the art that the specific detail need not be employed to practice the teachings herein. In other instances, well-known materials or methods have not been described in detail in order to avoid obscuring the present disclosure.

In the context of the present disclosure, power may be transferred via an energy transfer element (*e.g.,* a transformer) from an input (*e.g.,* from a primary) side to an output (*e.g.,* to a secondary) side according to a switching cycle. For instance, a primary switch may switch according to a switching cycle whereby a winding (*i.e.,* a primary winding) receives input power for part of the switching cycle and one or more secondary windings provide power for another part of the switching cycle. An energy transfer element may also be an energy storage element, as energy from an input source may be stored in the element during one part of a switching cycle, and the stored energy may be transferred to an output during another part of the switching cycle. A magnetic energy storage element may have only a single winding, as energy from a circuit may be stored in the element during one part of a switching cycle, and the stored energy may be removed from the element during another part of a switching cycle, not necessarily transferred to an output.

According to the teachings herein, when a transistor is in an "off-state" or "off" the transistor blocks current and/or does not substantially conduct current. Conversely, when a transistor is in an "on-state" or "on" the transistor is able to substantially conduct current. By way of example, in one embodiment, a high-voltage transistor comprises an N-channel metal-oxide-semiconductor (NMOS) field-effect transistor (FET) with the high-voltage being supported between the first terminal, a drain, and the second terminal, a source. In some embodiments an integrated controller circuit may be used to drive a power switch when regulating energy provided to a load. Also, for purposes of this disclosure, "ground" or "ground potential" refers to a reference voltage or potential against which all other voltages or potentials of an electronic circuit or Integrated circuit (IC) are defined or measured.

Switching power supplies may include magnetic components. In the context of the present disclosure, a magnetic component may be an energy transfer element and/or a magnetic energy storage element.

Switching power supplies may also include magnetic circuits to transfer energy. Magnetic circuits, in turn, may channel magnetic fields and/or magnetic flux in a magnetic core (*e.g.,* a transformer or inductor core).

Traditionally, magnetic components (*e.g.,* energy transfer elements, embedded transformers, coupled inductors, and the like) may be placed apart from circuit components (*e.g.,* power transistors, controllers, analog circuitry, digital circuitry, and the like) to isolate sensitive signals (*e.g.,* relatively small voltage signals) from magnetic interference. However, with the trend to miniaturize switching power supplies, there is a need to remove this constraint by integrating the magnetic component (energy transfer element) with circuit components.

For instance, a magnetic core may be embedded in a multi-layer printed circuit board (PCB) whereby windings are formed by traces enclosing the core. Additionally, there may be windows (*e.g.,* spaces) within the core referred to as winding windows.

Traditionally, as a best practice, the sensitive traces (*e.g.,* circuit traces carrying sensitive signals) may be routed around or away from the winding windows to avoid magnetic interference and/or half-winding effects. Unfortunately, this constraint conflicts with the need to integrate and miniaturize switching power supplies. Accordingly, there is a need to develop ways to pass sensitive signals through winding windows without degrading circuit performance.

Presented herein are a flux detection circuit for sensing magnetic flux via a magnetic flux probe and method therein. A magnetic flux probe comprising circuit elements and forming a loop around a magnetic core avails interconnection of a flux-sensitive trace across a winding window. The flux detection circuit is configured to measure an electromotive force (emf) of one or more elements of the loop; and at least one of the circuit elements may be adjustable (*e.g.,* may comprise a variable resistance). In this manner the magnetic flux probe and flux detection circuit may be calibrated to accurately detect a signal proportional to the time-varying magnetic flux and to provide the signal across a winding window. One example use for such a signal, as disclosed herein, is to provide an alternative way to detect the time varying current in a magnetic transfer element and use that information to control the operation of circuit elements within the power converter in a manner that is less subject to interference than more traditional control methods. A particular

3

example application of the magnetic flux probe, as disclosed herein, is to control the switching of a synchronous rectifier switch on the secondary side of a switched mode power converter.

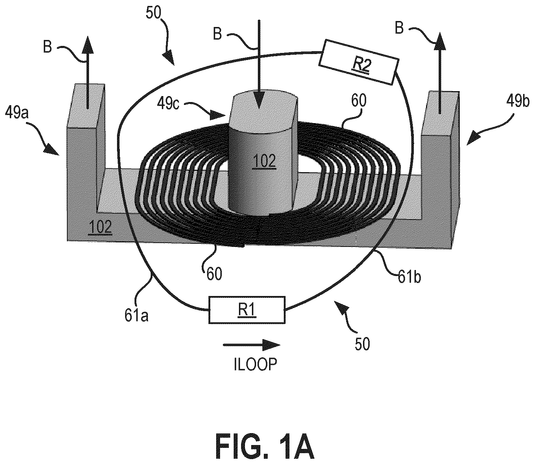

**FIG. 1A** illustrates a magnetic flux probe 50 according to an embodiment. The magnetic flux probe 50 comprises a resistor R1, a resistor R2, interconnect 61a, and interconnect 61b. The resistors R1-R2 are electrically coupled with interconnect 61a-b to create a loop (*i.e.*, "a loop" according to circuit and network theory).

Also illustrated is a magnetic core 102 (e.g., a ferrite core) and a winding 60 (*e.g.*, a primary winding). The magnetic core 102 may be an "E" section (*e.g.*, E-type core) portion of an embedded transformer, and the winding 60 may be formed using a printed circuit board (PCB) trace (*e.g.*, a copper PCB trace). The magnetic core 102 includes an outer leg 49a, an outer leg 49b, and a center leg 49c.

A magnetic flux density B may be generated within the magnetic core 102 due to an electric current within winding 60. The magnetic flux probe 50 forms a loop encircling a magnetic core 102; and an electromotive force (emf) and current ILOOP may be induced in response to a time varying magnetic flux density B.

Although the magnetic flux probe 50 is illustrated as enclosing the center leg 49c of magnetic core 102, other configurations are possible. For instance, the magnetic flux probe 50 may enclose (*i.e.*, encircle) any part (*e.g.,* outer leg 49a, outer leg 49b) of the magnetic core 102 channeling the magnetic flux density B. Moreover, other magnetic core types are possible.

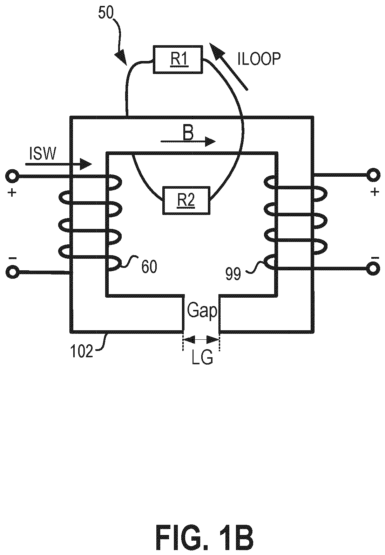

For instance, **FIG. 1B** illustrates a magnetic flux probe 50 according to another embodiment. The embodiment of FIG. 1B may be like that of FIG. 1A except it illustrates a single-phase core type configuration having a magnetic core 102, a winding 60 (*e.g.*, a primary winding), and a winding 99 (*e.g.*, a secondary winding). Also, like that of FIG. 1A, the magnetic flux probe 50 comprises a resistor R1, a resistor R2, interconnect 61a, and interconnect 61b.

Like that of FIG. 1A, the core 102 may be a ferrite core which is configured to sustain (channel) a magnetic flux density B generated by an electric current ISW within winding 60. Additionally, the core 102 may include a gap of dimension LG to improve core saturation characteristics; and winding 60, winding 99, and interconnect 61a-b may be realized with wire (*e.g.*, copper wire).

Also, like that of FIG. 1A, magnetic flux probe 50 forms a loop encircling magnetic core 102; and a current ILOOP may be induced in response to a time varying magnetic flux density B. Accordingly, the magnetic flux probe 50 may provide a probe signal in response to the time varying magnetic flux density B.

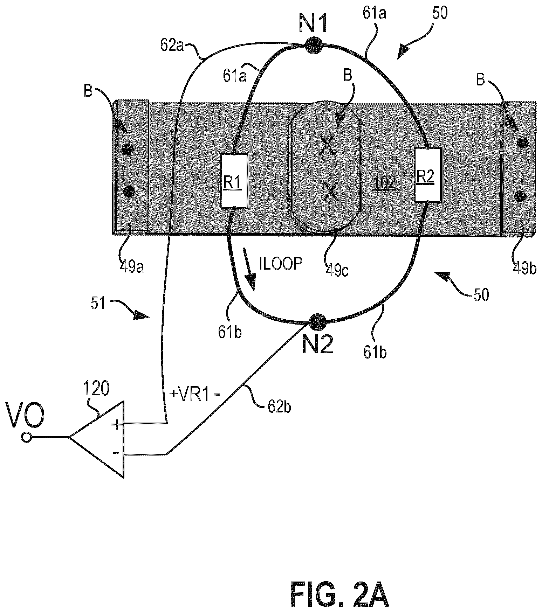

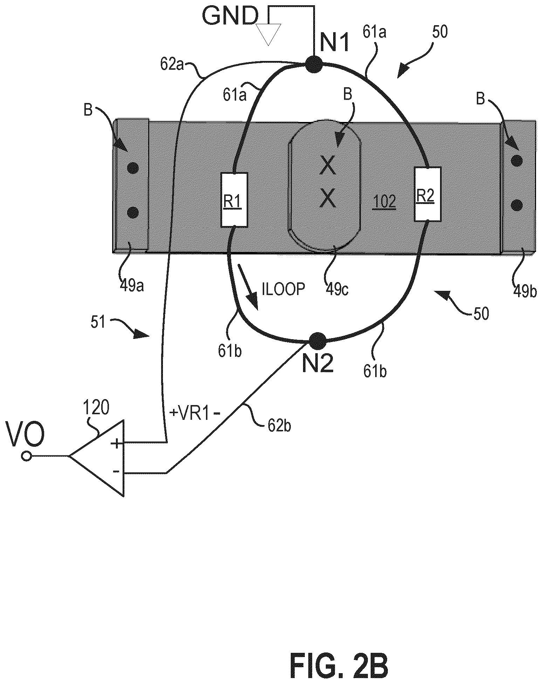

**FIG. 2A** and **FIG. 2B** illustrate a top-perspective view of a magnetic core 102 and interconnect routing for receiving a probe signal VR1 according to embodiments. The top perspective view shows the magnetic core 102 as an E-type core with an outer leg 49a, an outer leg 49b, and a center leg 49c. Magnetic flux density B is shown as entering the center leg 49c by an "X" vector symbol and as exiting the outer legs 48a-b by a "dot" vector symbol.

As described herein, the magnetic flux density B may be generated from a time varying signal (*e.g.,* an electric current ISW) within a winding (*e.g.*, winding 60).

The magnetic flux probe 50 encircles the center leg 49c. According to the laws of electromagnetic induction (*e.g.*, Faraday's law and Lenz's law), an electromotive force (emf) may be induced in the magnetic circuit probe 50 in response to a time varying magnetic flux density B, and alternatively, in response to a time varying magnetic flux Φ. The magnetic flux probe 50 encloses a magnetic flux Φ, which is a scalar quantity determined by a vector surface integral (*i.e.*, a dot product surface integral) of the total magnetic flux density B over the enclosed surface area of the center leg 49c.

Also illustrated are an interconnect 62a, an interconnect 62b, and a comparator 120. Interconnect 62a is electrically coupled to interconnect 61a at node N1, and interconnect 62b is electrically coupled to interconnect 61b at node N2.

The comparator 120 may monitor and/or measure a probe signal VR1 determined, at least in part, by a time varying magnetic flux Φ, a resistance RV1 of resistor R1, and a resistance RV2 of resistor R2. As illustrated, the probe signal VR1 may be an electromotive force (emf) induced on resistor R1 (*i.e.,* a voltage of resistor R1).

Moreover, the measurement (*i.e.*, the value of probe signal VR1 as seen by comparator 120) may further depend upon the placement of interconnect 62a-b. As illustrated, interconnect 62a-b are positioned such that the probe signal VR1, as seen by comparator 120, may be given by equation EQ. 1 in terms of the resistance RV1, the total loop resistance RTOT, and the time rate of change of the flux Φ enclosed by the magnetic flux probe 50.

$$|VR1| = \frac{RV1}{RTOT}\left|\frac{d\Phi}{dt}\right| \qquad\qquad \text{EQ. 1}$$

The sign (plus or minus) of probe signal VR1 may depend, in part, upon the time rate of change (*i.e.,* the derivative) of the flux Φ and corresponding direction of the induced current ILOOP.

When the interconnect resistance of interconnect 61a-b is negligible compared to the resistances RV1 and RV2, then the total resistance RTOT may be given by the sum of the resistances RV1 and RV2; and equation EQ. 1 may be rewritten by the following equation EQ. 2.

$$|VR1| = \frac{RV1}{RV1 + RV2}\left|\frac{d\Phi}{dt}\right| \qquad\qquad EQ. 2$$

Accordingly, the voltage magnitude of probe signal VR1 may be trimmed to a select value by adjusting one or both of resistances RV1 and RV2. For instance, resistor R2 may be a variable or trimmable resistor. This may advantageously allow trimming the voltage magnitude of probe signal VR1 so that the comparator output changes state (*i.e.*, changes detection signal VO) according to a trimmed target value.

The embodiment of FIG. 2B is like that of FIG. 2A, except node N1 may be connected to ground GND so that the measured voltage of probe signal VR1 is referenced to ground GND. Although FIG. 2A and FIG. 2B illustrate a magnetic flux probe 50 as having two resistors R1-R2, other configurations having greater or fewer resistors may be possible.

Additionally, other configurations for measuring probe signal VR1 and providing detection signal VO may be possible. Other configurations may include one or more magnetic flux probes to provide probe signals to comparators and/or other circuitry (*e.g.*, operational amplifiers).

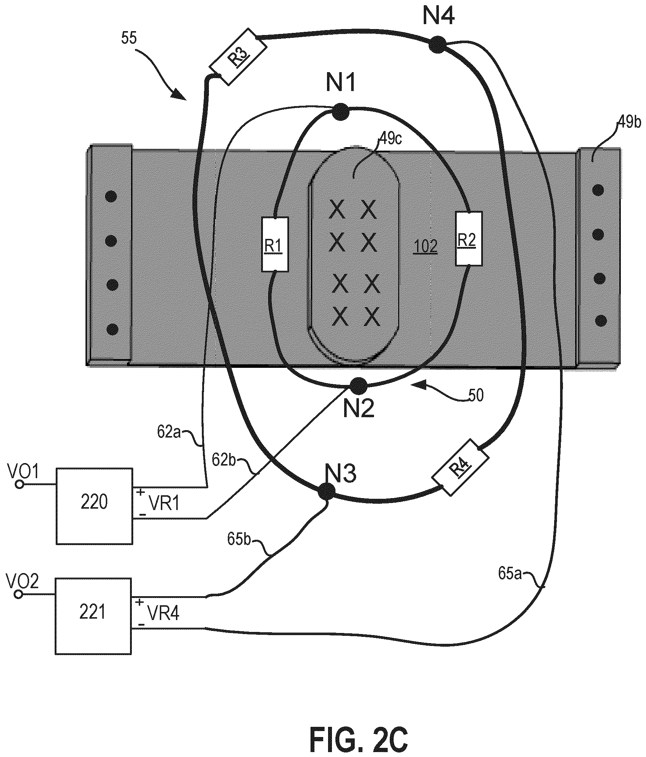

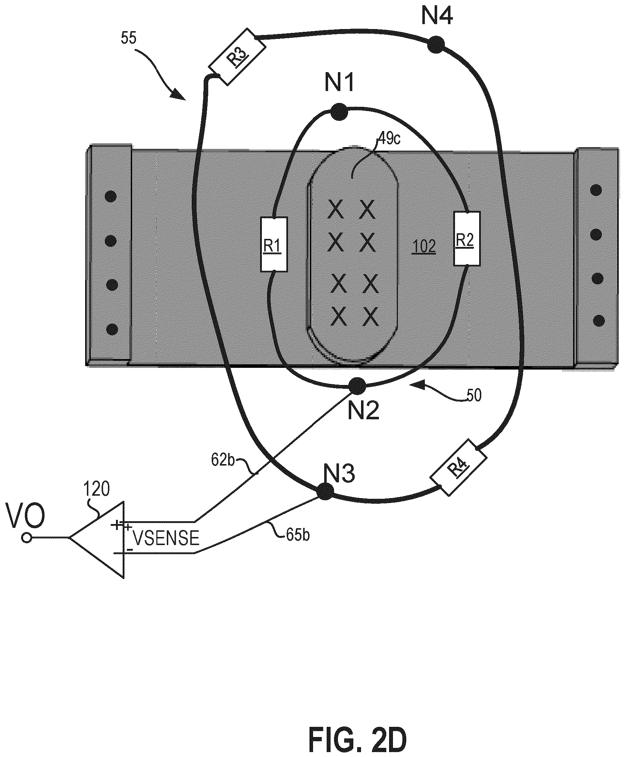

For instance, **FIG. 2C** illustrates a top-perspective view of a magnetic core 102 and interconnect routing for receiving one or more probe signals VR1, VR4 according to an embodiment. Unlike the embodiments of FIG. 2A and FIG. 2B, the embodiments of FIG. 2C and FIG. 2D include an additional magnetic flux probe 55, circuitry 220, and circuitry 221.

Magnetic flux probe 55 comprises a resistor R3, a resistor R4, interconnect 65a, and interconnect 65b. The resistors R3-R4 are electrically coupled with interconnect 65a-b to create a loop; and the discussion above with respect to the operation of magnetic flux probe 50 and resistors R1-R2 may also apply to magnetic flux probe 55.

Unlike the embodiments of FIG. 2A and FIG. 2B, the embodiment of FIG. 2C includes circuitry 220 instead of a comparator 120. Like comparator 120, circuitry 220 may receive probe signal VR1. Circuitry 220 may include active components and/or passive components which, in response to probe signal VR1, allow circuitry 220 to provide a detection signal VO1. For instance, circuitry 220 may comprise an operational amplifier and/or passive components which provide detection signal VO1 as a continuous analog signal. Alternatively, circuitry 220 may comprise digital components including, but not limited to, analog-to-digital converters, logic gates, digital signal processors, and the like.

Also illustrated are an interconnect 65a and interconnect 65b which are respectively coupled to nodes N4 and N3 for providing a probe signal VR4 (*e.g.*, an emf induced on resistor R4) to circuitry 221. Circuitry 221 may be like that of circuitry 220 and provide detection signal VO2 in response to probe signal VR4.

**FIG. 2D** also illustrates a top-perspective view of a magnetic core 102 and interconnect routing according to another embodiment having one or more magnetic flux probes 50, 55. The embodiment of FIG. 2D is like that of FIG. 2C except it includes comparator 120, and comparator 120 receives a probe signal VSENSE via interconnect 62b and interconnect 65b. As illustrated, the comparator 120 may provide detection signal VO in response to a potential between nodes N2 and N3.

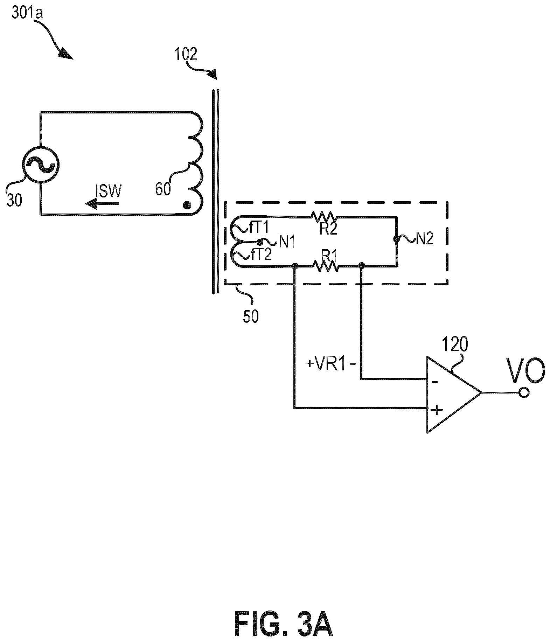

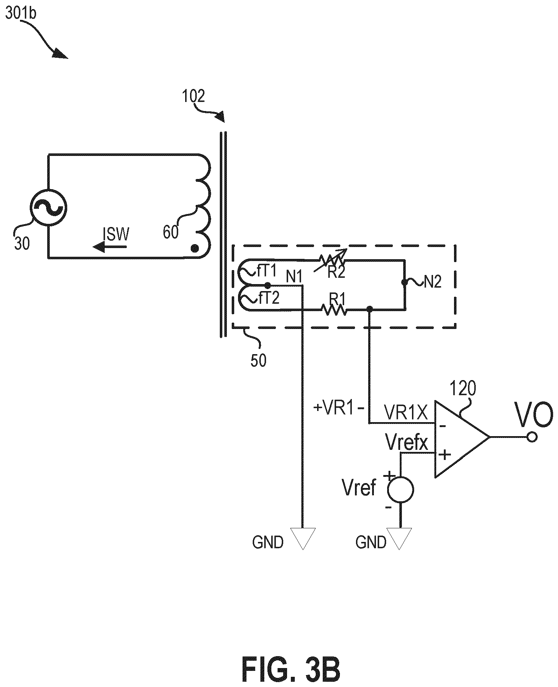

**FIG. 3A** and **FIG. 3B** illustrate schematics 301a-b including a magnetic flux probe 50. Schematics 301a-b include the magnetic core 102, a winding 60 (*e.g.*, a primary winding), and comparator 120. Winding 60 may receive a time varying electric current ISW provided from a signal source 30. In turn, a magnetic flux density B may be generated in magnetic core 102.

As depicted in schematic 301a, magnetic flux probe 50 includes a partial turn winding fT1, a partial turn winding fT2, resistor R1, and resistor R2. Partial turn winding fT1 and resistor R2 are electrically coupled between node N1 and node N2; and partial turn winding fT2 and resistor R1 are electrically coupled between node N1 and node N2.

As illustrated, the partial turn windings fT1, fT2, and resistors R1, R2 may represent a loop enclosing the magnetic core 102 including nodes N1, N2. For instance, the circuit path including partial turn winding fT2 and resistor R1 from node N1 to node N2 may depict interconnect 61a, interconnect 61b, and resistor R1 routed through the winding window between outer leg 49a and center leg 49c. Similarly, the circuit path including partial turn winding fT1 and resistor R2 may depict interconnect 61a, interconnect 61b, and resistor R2 routed through the winding window between outer leg 49b and center leg 49c.

As illustrated by schematic 301a, the comparator 120 is configured to measure (*i.e.*, to receive) probe signal VR1 from the magnetic flux probe 50. Additionally, the probe signal VR1 may be the voltage across resistor R1. For instance, as discussed above with respect to FIG. 2A, the comparator 120 may receive probe signal VR1 (*i.e.*, the voltage across resistor R1) when interconnect 62a and interconnect 62b are routed such that they do not enclose the time varying magnetic flux density B. In this manner the inverting and non-inverting inputs of comparator 120 may be respectively coupled (*i.e.*, electrically coupled) to nodes N2 and N1 such that the comparator measures probe signal VR1 as the voltage across resistor R1.

As illustrated by schematic 301b in **FIG. 3B**, the comparator 120 may be configured to measure (*i.e.*, compare) probe signal VR1 to a reference voltage Vref (*e.g.*, zero point one (0.1) volts). Node N1 may be connected to ground GND; accordingly, the inverting input of comparator 120 may receive a node-relative probe signal VR1X with respect to ground GND. Additionally, the non-inverting input of comparator 120 may receive a node-relative reference voltage Vrefx with respect to ground GND.

Also, unlike that of schematic 301a, resistor R2 of schematic 301b may have a variable resistance RV2. As discussed above with regards to **FIG. 2A** and **FIG. 2B,** resistor R2 may be trimmed and/or adjusted for attaining a target value (*i.e.,* a target voltage of probe signal VR1) for which the comparator 120 will change state.

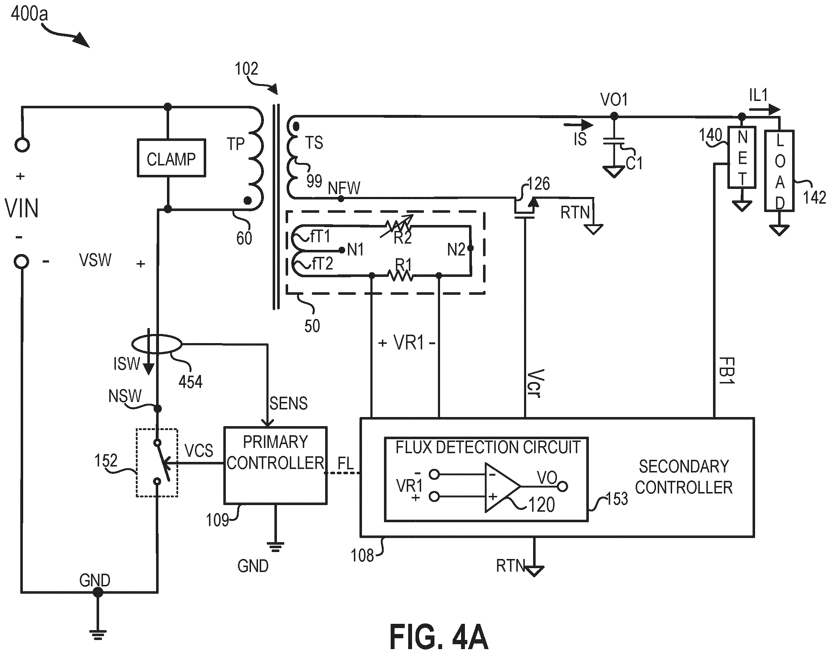

**FIG. 4A** illustrates a schematic of an isolated flyback converter 400a according to an embodiment. The flyback converter 400a may receive input power comprising an input voltage VIN and an electric current ISW (*e.g.*, a switch current). During switching cycles of a primary switch 152, winding 60 (*e.g.*, a primary winding) receives electric current ISW and, in response, generates a magnetic flux density B within the magnetic core 102. As a result of the magnetic flux density B, power may be transferred to winding 99 (*e.g.*, a secondary winding) and to load 142 in the form of output power comprising output voltage VO1 and load current II,1.

Moreover, input power signals (*e.g.*, input voltage VIN) may be relative to a primary ground (*e.g.*, ground GND) while output power signals (*e.g.*, output voltage VO1) may be relative to a secondary ground (*e.g.*, secondary ground RTN). For instance, as illustrated the primary controller 109 is referenced to ground GND while the secondary controller 108 and load 142 are referenced to a galvanically isolated secondary ground RTN.

As illustrated, flyback converter 400a includes a primary controller 109, a primary switch 152, and a winding 60 (*e.g.*, a primary winding). The primary controller 109 may drive the primary switch 152 with a gate signal VCS so that winding 60 receives electric current ISW according to a switching cycle. In response to the electric current ISW in winding 60, magnetic flux density B may be generated within the magnetic core 102.

The peak value of electric current ISW may be determined, in part, by sense signal SENS. As illustrated, sense signal SENS may be provided to the primary controller 109 via sense element 454. When the electric current ISW reaches a target peak value, then the primary controller may turn primary switch 152 off in response to sense signal SENS.

Additionally, flyback converter 400a may include a secondary controller 108, a synchronous rectifier 126, a feedback network 140, and winding 99 (*e.g.,* a secondary winding). Winding 99 may be electrically coupled to the (drain) of synchronous rectifier 126 (*e.g.,* an NFET with a gate, source, and drain) at node NFW (*e.g.,* a secondary winding node).

The secondary controller 108 may receive feedback signal FB 1 and, in response, convey information to the primary controller 109 via signal FL. For instance, if the feedback signal FB 1 indicates that the load requires more power (*e.g.*, that the output voltage VO1 is drooping), then the secondary controller 108 may provide a pulse via signal FL. In response, the primary controller 109 may provide gate signal VCS so that primary switch 152 turns on.

Accordingly, power delivered to load 142 may be regulated to a specified output voltage VO1 as load current IL1 varies with the load demand. Also, the output capacitor C1 may be used to filter output ripple.

As illustrated, the synchronous rectifier 126 may be realized as an N-channel field effect transistor (NFET). During each switching cycle of the primary switch 152, the synchronous rectifier 126 may receive a control signal Vcr from the secondary controller 108. As described herein, the control signal Vcr may be provided to the synchronous rectifier 126 based, in part, upon a switching state of the primary switch 152.

For instance, if the primary switch 152 transitions from on to off, then the secondary controller 108 may provide control signal Vcr to turn the synchronous rectifier 126 on so that winding 99 (*e.g.*, a secondary winding) may sustain secondary current IS. This may advantageously allow efficient transfer of power to load 142 while a magnetic flux density B exists within the magnetic core 102.

Additionally, if during the switching cycle the secondary current IS diminishes such that the flyback converter operates in discontinuous mode (DCM); then the secondary controller 108 may turn off the synchronous rectifier 126 once the secondary current reduces to substantially zero.

Also, according to the teachings herein, the magnetic flux probe 50 may advantageously provide a probe signal VR1 which is indicative of the switching state of the primary switch and of the mode of operation (*e.g.*, DCM). For instance, when the primary switch 152 turns off, then the rate of change of the magnetic flux density B may abruptly change sign (*e.g.*, plus to minus). Therefore, the probe signal VR1 may abruptly change sign indicative of a transition of primary switch 152.

Additionally, the voltage magnitude of probe signal VR1 may indicate when the magnetic flux density B reduces below a target magnitude. Accordingly, the probe signal VR1 may also be indicative of DCM and the onset of ringing.

As described herein, the secondary controller 108 may further provide the control signal Vcr to the synchronous rectifier 126 based, at least in part, upon detection signal VO from flux detection circuit 153.

As illustrated, flux detection circuit 153 may comprise comparator 120 which, like that of FIG. 3A, measures (*i.e.*, compares) probe signal VR1 as a differential voltage between the non-inverting and inverting input terminals. Accordingly, comparator 120 may provide detection signal VO based upon the value of probe signal VR1. The secondary controller 108 may, in turn, provide control signal Vcr to turn the synchronous rectifier on and/or off based, at least in part, upon detection signal VO.

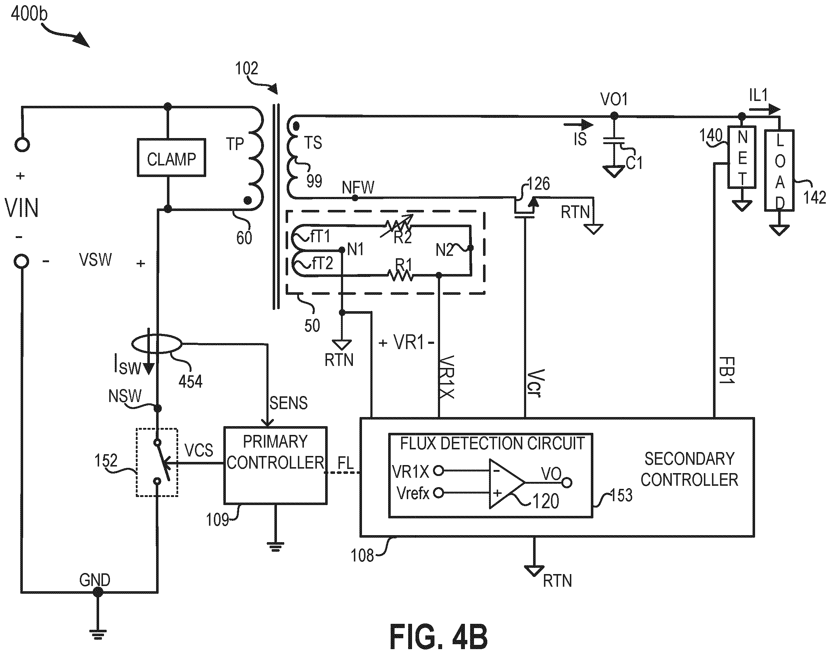

**FIG. 4B** illustrates a schematic of a flyback converter 400b according to another embodiment. Flyback converter 400b is like flyback converter 400a except node NI may be electrically coupled to secondary ground RTN such that inverting input of comparator 120 may receive node-relative probe signal VR1X with respect to secondary ground RTN. Additionally, the non-inverting input of comparator 120 may receive a node-relative reference voltage Vrefx with respect to secondary ground RTN such that comparator 120 may compare probe signal VR1 to reference voltage Vref.

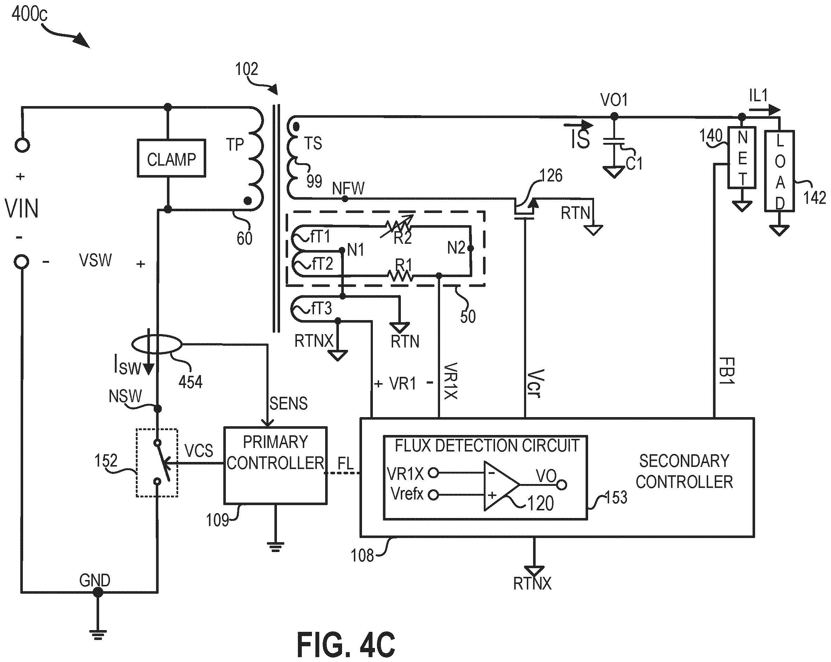

**FIG. 4C** illustrates a schematic of a flyback converter 400c according to another embodiment. Flyback converter 400c is like flyback converter 400b, except it includes an additional partial turn winding fT3. As described herein, partial turn winding fT3 may represent a partial turn which does not completely encircle the magnetic core. As illustrated partial turn winding fT3 may be coupled to secondary ground RTN and to a routed secondary ground RTNX.

Also, as presented herein, the routed secondary ground RTNX and secondary ground RTN may be physically located on opposite sides of a winding window (*e.g.*, a winding window defined by outer leg 49a and center leg 49c). As one of skill in the art may appreciate, the partial turn winding fT3 may give rise to half-winding effects and/or lead to unwanted variability in the winding turns ratio between the number of primary turns TP and the number of secondary turns TS. For instance, when the synchronous rectifier 126 is on, the partial turn winding fT3 may effectively couple to winding 99 (*e.g.*, secondary winding) thereby introducing an additional partial turn.

Under certain operating conditions and configurations, this may vary the effective number of secondary turns TS if the partial turn winding fT3 becomes part of a loop surrounding the magnetic core 102. For instance, a loop may include the partial turn winding fT3 if additional interconnect and/or external wires are connected to both secondary ground RTN and routed secondary ground RTNX. Ideally, a layout may follow best practices so that the partial turn winding fT3 is not part of a loop; under these best practice conditions, the secondary ground RTN and the routed secondary ground RTNX may be substantially equal without magnetic interference.

Accordingly, the node-relative reference voltage Vrefx and node-relative probe signal VR1X of flyback 400c may be equivalent to that of flyback 400b when the partial turn winding fT3 is not part of a loop surrounding the core (*e.g.*, the center leg 49c).

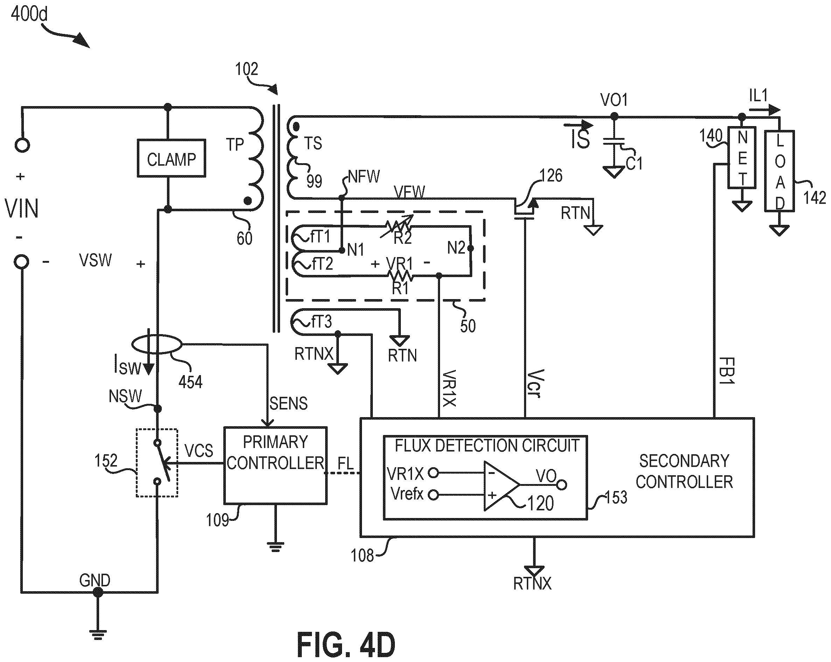

**FIG. 4D** illustrates a schematic of a flyback converter 400d according to another embodiment. Flyback converter 400d is like flyback converter 400b except node N2 may be electrically coupled with node NFW (*e.g.*, a secondary winding node) so that the node-relative probe signal VR1X is with respect to a winding voltage VFW instead of secondary ground RTN.

The winding voltage VFW may vary during a switching cycle and be a function of the switching state of synchronous rectifier 126. When synchronous rectifier 126 is on, then the winding voltage VFW may be substantially equal to or less than the value of secondary ground RTN (*e.g.*, zero volts). For instance, the winding voltage VFW may be less than that of secondary ground RTN by virtue of a drain-to-source voltage of synchronous rectifier 126. Therefore, when the synchronous rectifier 126 is on, the node-relative probe signal VR1X may vary due, in part, to the drain-to-source voltage of synchronous rectifier 126. Accordingly, in the embodiment of flyback converter 400d, the comparator 120 may provide the detection signal VO based, at least in part, upon a drain-to-source voltage of synchronous rectifier 126 and upon the node-relative probe signal VR1X.

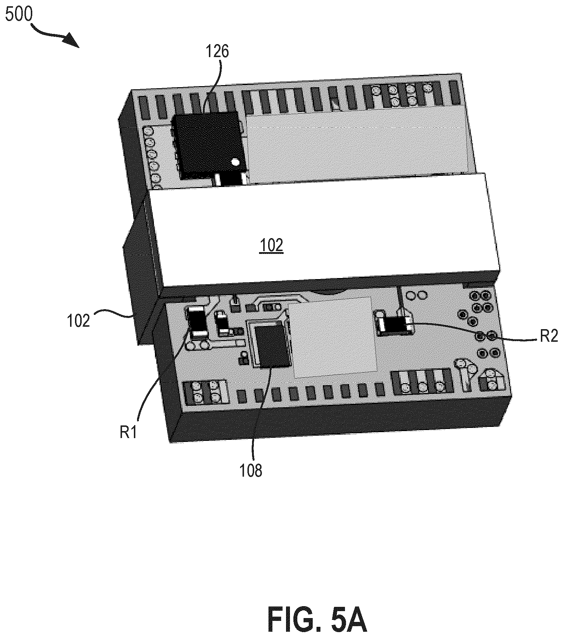

**FIG. 5A** illustrates a three-dimensional (3D) top view perspective of a portion of a flyback converter 500 according to a printed circuit board (PCB) embodiment. The flyback converter 500 includes a magnetic core 102, a synchronous rectifier 126, a resistor R1, a resistor R2, and a secondary controller 108. Magnetic core 102 may be an EI-type core. According to the teachings herein, there may be a magnetic flux density B generated within the magnetic core 102; and there may be a need to turn the synchronous rectifier 126 on and off based, at least in part, upon a switching state (*e.g.*, a switching state of a primary switch) and/or upon a mode of operation (*e.g.*, DCM).

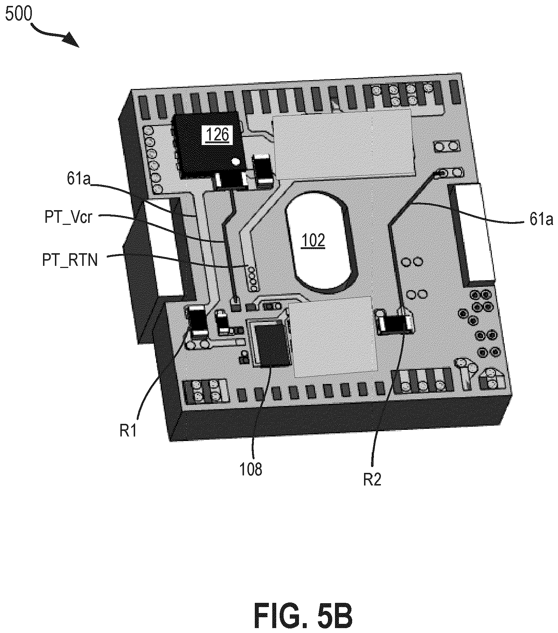

**FIG. 5B** illustrates a three-dimensional (3D) top view perspective of the portion of a flyback converter 500 according to the embodiment of **FIG. 5A.** In **FIG. 5B,** a portion of the magnetic core 102 (*e.g.*, an I-type segment) has been removed to reveal more of the relevant underlying traces and interconnects. The view of **FIG. 5B** reveals interconnect 61a, a trace PT_Vcr, and a trace PT_RTN. Interconnect 61a is electrically coupled to resistor R1 and to resistor R2. Synchronous rectifier 126 may be an NFET including a gate which is electrically coupled to trace PT_Vcr, and trace PT_RTN may be electrically coupled to secondary ground RTN.

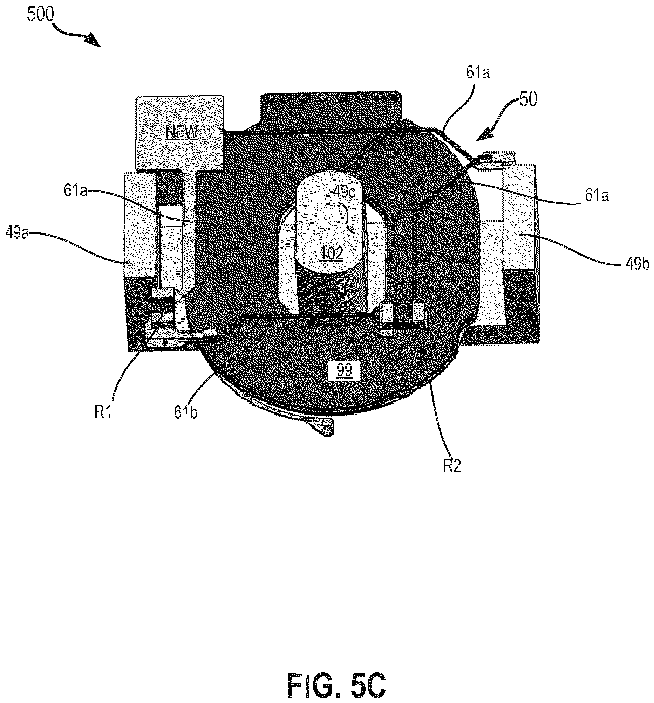

**FIG. 5C** illustrates a three-dimensional (3D) top view perspective of a portion of a flyback converter 500 according to the embodiment of **FIG. 5A.** In the top view of **FIG. 5C,** materials have been removed to reveal a magnetic flux probe 50 with respect to the magnetic core 102 and with respect to a winding 99 (*e.g.*, a secondary winding). The magnetic flux probe 50 includes interconnect 61a, interconnect 61b, resistor R1, and resistor R2. As illustrated the magnetic flux probe 50 may form a loop around a center leg 49c of the magnetic core 102. Also, as described herein, the magnetic flux probe 50 may provide a probe signal VR1 in response to the time varying magnetic flux density B.

In an example embodiment, interconnect 61a may include a printed circuit board (PCB) via, to route interconnect 61a on more than one layer of the PCB. Additional PCB vias may route interconnect 61a at node NFW and electrically couple node NFW to interconnect 61a.

Also, interconnect 61b may be electrically coupled to resistor R2 and to resistor R1 with vias. This may allow interconnect 61b to be routed on a second layer of the PCB separated from the layer including resistors R1, R2.

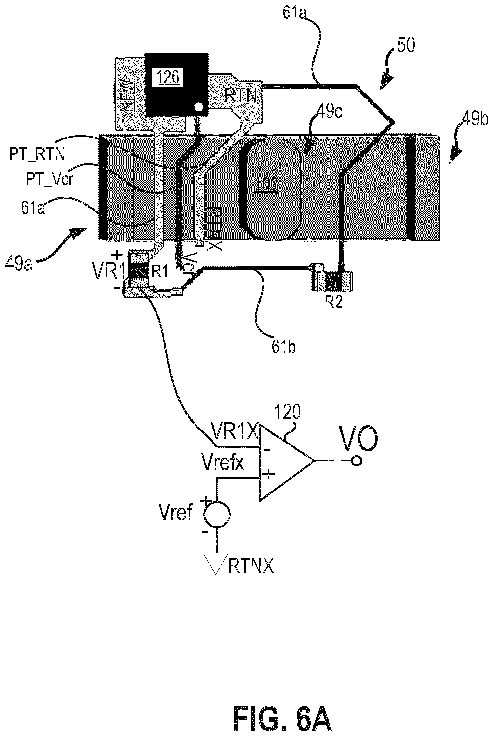

**FIG. 6A** illustrates interconnect routing of a magnetic flux probe 50 and interconnect routing according to the embodiment of **FIG. 5A.** The magnetic flux probe 50 includes interconnect 61a, interconnect 61b, resistor R1, resistor R2 and may form a loop around the center leg 49c of core 102. The synchronous rectifier 126 may be an N-type field effect transistor (NFET) having a drain electrically coupled to node NFW (*e.g.*, a secondary winding node), a source electrically coupled to secondary ground RTN, and a gate electrically coupled to trace PT_Vcr.

In accordance with the teachings herein, the magnetic flux probe 50 may provide probe signal VR1. As illustrated, probe signal VR1 may be a voltage relative to routed secondary ground RTNX by virtue of trace PT_RTN, routed across the winding window between outer leg 49a and center leg 49c. As discussed above with regards to **FIG. 4C,** routed secondary ground RTNX may be equivalent to secondary ground RTN when trace PT_RTN is excluded from a loop enclosing core 102.

Comparator 120 may compare node-relative probe signal VR1X to a node-relative reference voltage Vrefx, and in response provide a detection signal VO. Also, like that of flyback converter 400d, the node-relative probe signal VR1X may be relative to winding voltage VFW. The node-relative reference voltage Vrefx may, for example, be minus zero point three volts (-0.3V) relative to the routed secondary ground RTNX. Therefore, according to the operation of comparator 120, detection signal VO may be high when node-relative probe signal VR1X is less than negative zero point three volts (-0.3V) and may be low when node-relative probe signal VR1X is greater than -0.3V.

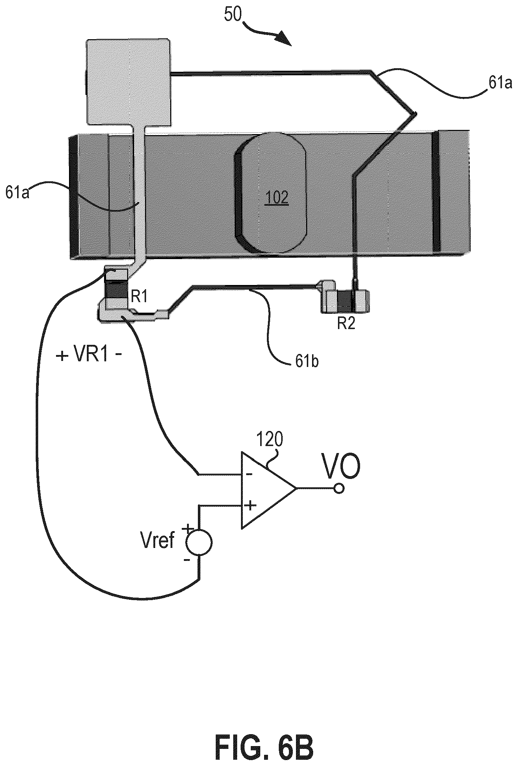

**FIG. 6B** illustrates interconnect routing of a magnetic flux probe 50 and interconnect routing according to another embodiment. The embodiment of **FIG. 6B** may be like that of **FIG. 6A** except node N2 is not connected to a fixed potential (*e.g.*, return ground RTN) nor to node NFW. As illustrated, the probe signal VR1 may be derived from the voltage across resistor R1. Accordingly, the detection signal VO may be high when probe signal VR1 plus reference voltage Vref is greater than zero and low when probe signal VR1 plus reference voltage Vref is less than zero.

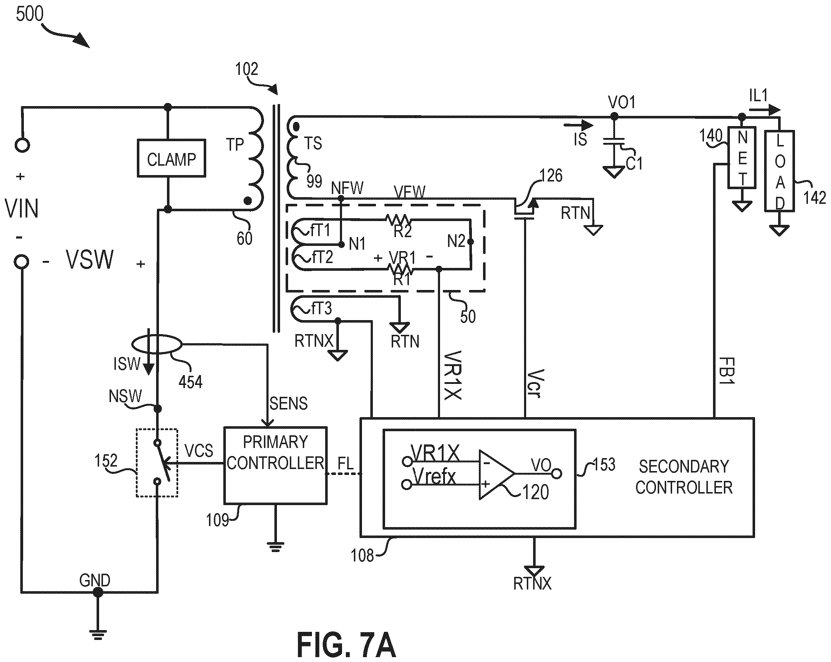

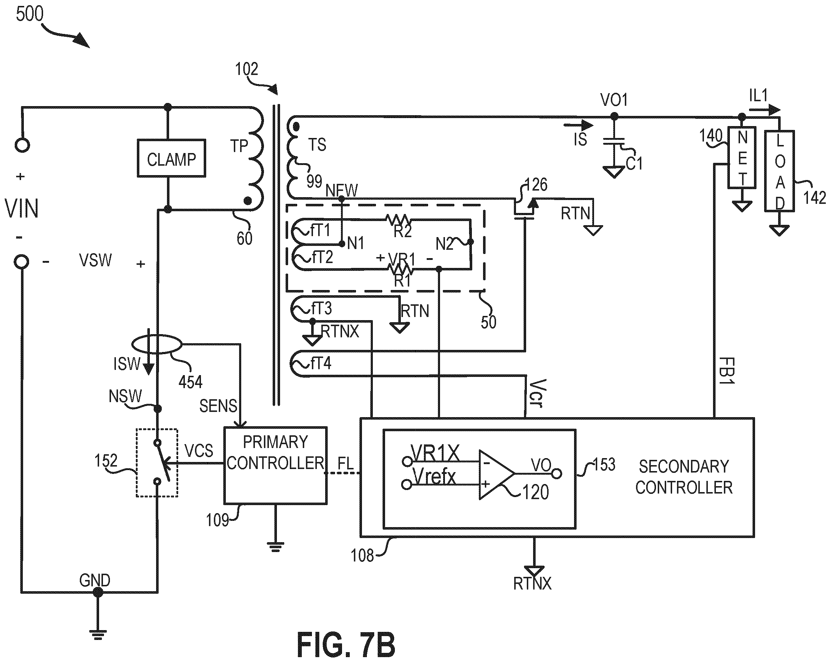

**FIG.7A** and **FIG. 7B** illustrate schematic diagrams of flyback converter 500 according to the embodiment of **FIG. 6A.** Flyback converter 500 may be like flyback converter 400d, except the magnetic flux probe 50 and flux detection circuit 153 may be routed according to the configuration of **FIG. 6A;** and the resistor R2 may comprise a fixed resistance. **FIG. 7B** includes partial turn winding fT4 to schematically represent trace PT_Vcr across the winding window between outer leg 49a and center leg 49c.

As discussed herein, if trace PT_Vcr is excluded from a loop enclosing the time varying magnetic flux B (*i.e.,* is not part of a loop enclosing the magnetic core 102), then control signal Vcr may drive the control terminal (*i.e.*, gate) of synchronous rectifier 126 without magnetic interference from the core.

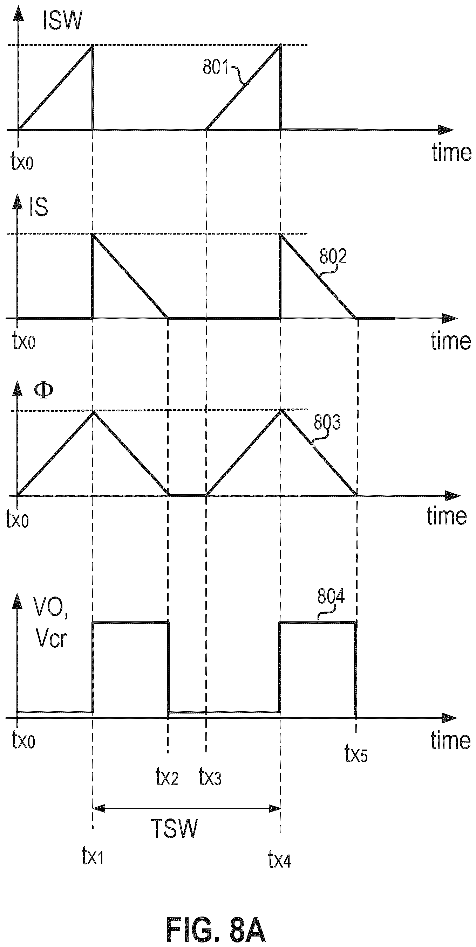

**FIG. 8A** illustrates waveforms 801-804 according to the teachings herein. Waveform 801 may correspond to electric current ISW in winding 60 during switching cycles of primary switch 152. Waveform 802 may correspond to secondary current IS in winding 99 during switching cycles of primary switch 152. Waveform 803 may correspond to magnetic flux Φ in magnetic core 102 during switching cycles of primary switch 152; and waveform 804 may correspond to detection signal VO and/or control signal Vcr.

From time tx0 to time tx1 and from time tx3 to time tx4, electric current ISW increases in winding 60 thereby generating magnetic flux Φ in magnetic core 102. Accordingly, the magnetic flux Φ may increase from time tx0 to time tx1 and from time tx3 to time tx4.

From time tx1 to time tx2 and from time tx4 to time tx5 the electric current ISW is zero so that no current is in winding 60. Accordingly, the magnetic flux Φ may decrease from time tx1 to time tx2 and from time tx4 to time tx5. As the magnetic flux Φ decreases, secondary current IS may be provided to winding 99 according to waveform 802 while the magnetic flux Φ decreases in the magnetic core 102.

Also, as illustrated, a switching period TSW is delineated from time tx1 to time tx4; and from time tx2 to time tx3 the magnetic flux Φ may reduce to zero or substantially zero during a discontinuous conduction mode (DCM). Accordingly, the secondary current IS may reduce to zero or substantially zero in winding 99.

According to the teachings herein, a magnetic flux probe 50 may provide a probe signal VR1 in response to the time derivative of waveform 803 (*i.e.,* in response to the time varying magnetic flux Φ). In response to the probe signal VR1, a flux detection circuit 153 may provide a detection signal VO, and a secondary controller 108 may provide control signal Vcr according to waveform 804.

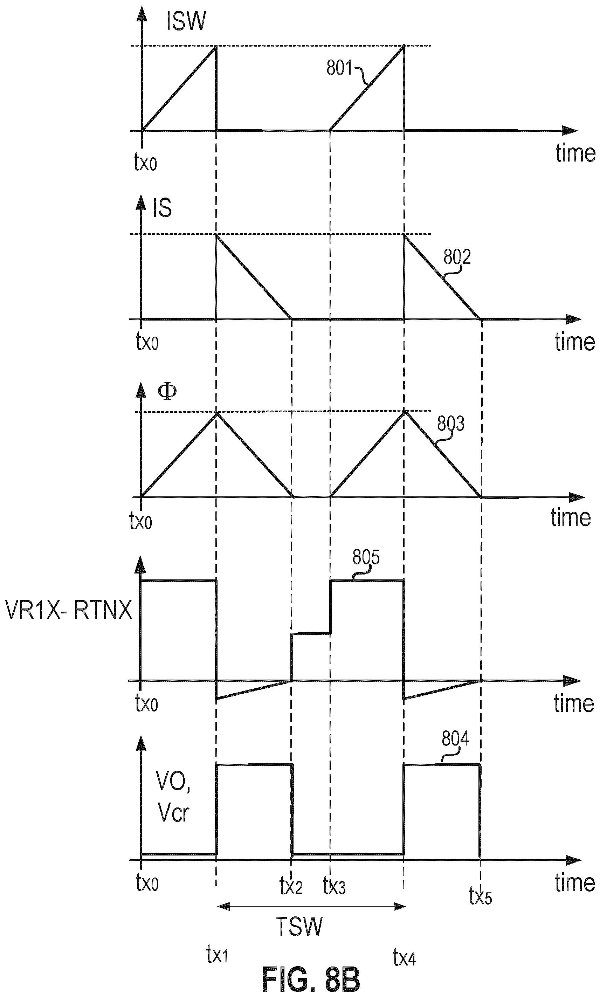

**FIG. 8B** illustrates waveforms 801-805 according to the teachings herein. Waveform 805 may correspond with the difference between the node relative probe signal VR1X and the routed secondary ground RTNX according to an embodiment using node-relative probe signal VR1X (*e.g.,* **FIG. 4D** and/or **FIG. 7B**). As illustrated, the difference between the node relative probe signal VR1X and routed secondary ground RTNX may reduce below zero volts at times tx1, tx4 and increase towards zero volts at times tx2, tx5 such that waveform 804 transitions high at times tx1, tx4 and transitions low at times tx2, tx5.

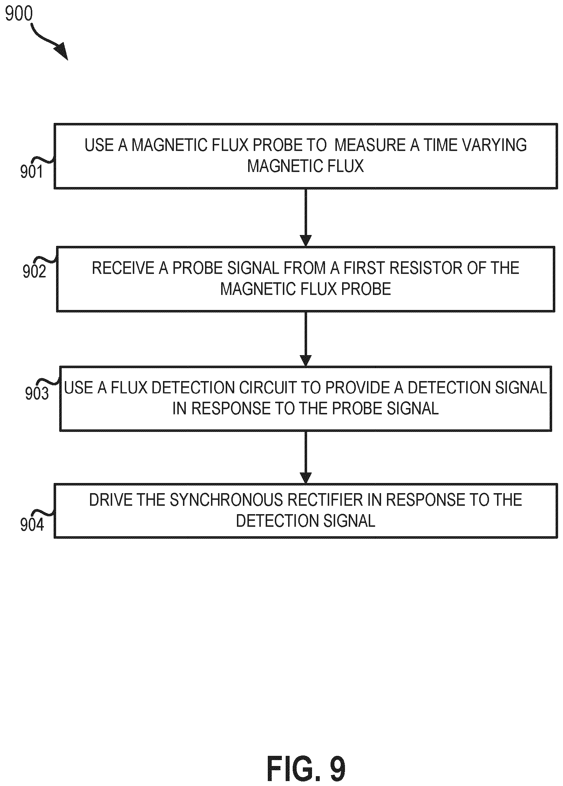

**FIG. 9** illustrates a conceptual flow diagram 900 for controlling a synchronous rectifier 126 during a switching cycle TSW. Step 901 may correspond with using a magnetic flux probe 50 to measure a time varying magnetic flux Φ. Step 902 may correspond with receiving a probe signal VR1 from a first resistor R1 of the magnetic flux probe 50. Step 903 may correspond with using a flux detection circuit 153 to provide a detection signal VO in response to the probe signal VR1; and step 904 may correspond with driving the synchronous rectifier (*i.e.*, providing control signal Vcr) in response to the detection signal VO.

CONCLUSION

The above description of illustrated examples of the present disclosure, including what is described in the Abstract are not intended to be exhaustive or to be limitation to the precise forms disclosed. While specific embodiments of, and examples for flux detection circuits and methods for sensing magnetic flux via a magnetic flux probe are described herein for illustrative purposes, various equivalent modifications are possible without departing from the broader spirit and scope of the present disclosure. Indeed, it is appreciated that the specific example voltages, currents, frequencies, power range values, times, etc., are provided for explanation purposes and that other values may also be employed in other embodiments and examples in accordance with the teachings herein.

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

Furthermore, reference throughout this specification to "one embodiment", "an embodiment", "one example" or "an example" means that a particular feature, structure or characteristic described in connection with the embodiment or example is included in at least one embodiment of flux detection circuits and methods for sensing magnetic flux via a magnetic flux probe. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

Moreover, conditional language used herein, such as, among others, "can," "could," "might," "may," "e.g.," "for example," "such as" and the like, unless specifically stated otherwise or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or that one or more embodiments necessarily include logic for deciding whether these features, elements and/or states are included or are to be performed in any particular embodiment.

While certain embodiments have been described, these embodiments have been presented by way of example only, and are not intended to limit the scope of the disclosure. Indeed, the novel apparatus, methods, and systems described herein may be embodied in a variety of other forms; furthermore, various omissions, substitutions and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible.

EMBODIMENTS

Although the present invention is defined in the attached claims, it should be understood that the present invention can also (alternatively) be defined in accordance with the following embodiments:

1. A switching power supply comprising:

an energy transfer element comprising a primary winding, a secondary winding, and a core;
a primary switch electrically coupled to the primary winding and configured to generate a magnetic flux within the core according to a switching cycle;
a magnetic flux probe comprising a first resistor and a second resistor, wherein the magnetic flux probe is configured to form a loop enclosing the magnetic flux and to provide a probe signal in proportion to a time derivative of the magnetic flux; and

a synchronous rectifier (SR) electrically coupled to the secondary winding and configured to receive a control signal based, at least in part, upon the probe signal.

2. The switching power supply of embodiment 1, wherein the switching power supply is a flyback converter.

3. The switching power supply of embodiment 1, wherein the energy transfer element is a magnetic component.

4. The switching power supply of embodiment 3, wherein the magnetic component is an embedded transformer.

5. The switching power supply of embodiment 1, wherein the synchronous rectifier is an N-type field effect transistor (NFET).

6. The switching power supply of embodiment 1, wherein the magnetic flux probe comprises a first node electrically coupled to the first resistor.

7. The switching power supply of embodiment 1, wherein the probe signal is determined, at least in part, by an electromotive force (emf) of the first resistor.

8. The switching power supply of embodiment 1, wherein the probe signal is proportional to a resistance of the first resistor and inversely proportional to a total resistance of the magnetic flux probe.

9. The switching power supply of embodiment 8, wherein the total resistance of the magnetic flux probe comprises the resistance of the first resistor and a resistance of the second resistor.

10. The switching power supply of embodiment 1, wherein the second resistor is a variable resistor.

11. The switching power supply of embodiment 1, wherein the second resistor is a trimmable resistor.

12. The switching power supply of embodiment 1, wherein the magnetic flux probe comprises a first node electrically coupled to the secondary winding.

13. The switching power supply of embodiment 12, wherein the first node is electrically coupled to the synchronous rectifier.

14. The switching power supply of embodiment 1 further comprising:

a flux detection circuit configured to provide a detection signal in response to the probe signal, wherein the synchronous rectifier is configured to receive a control signal based, at least in part, upon the detection signal.

15. The switching power supply of embodiment 14, wherein the flux detection circuit comprises a comparator configured to provide the detection signal in response to a comparison of the probe signal to a reference voltage.

16. The switching power supply of embodiment 15, wherein the reference voltage has a magnitude of zero-point one volts (0. 1V) to zero-point five volts (0.5V).

17. The switching power supply of embodiment 1, wherein the magnetic flux probe further comprises:

at least one interconnect electrically coupled between the first resistor and the second resistor.

18. The switching power supply of embodiment 17, wherein the at least one interconnect comprises a printed circuit board trace.

19. The switching power supply of embodiment 17, wherein the at least one interconnect comprises a wire.

20. A method of controlling a synchronous rectifier during a switching cycle comprising:

using a magnetic flux probe to measure a time varying magnetic flux;
receiving a probe signal from a first resistor of the magnetic flux probe;
using a flux detection circuit to provide a detection signal in response to the probe signal; and
driving the synchronous rectifier in response to the detection signal.

21. The method of embodiment 20, further comprising:
adjusting a variable resistor to determine a magnitude of the probe signal.

22. The method of embodiment 20, wherein the synchronous rectifier is an N-type field effect transistor (NFET).

23. The method of embodiment 20, wherein using the flux detection circuit to provide the detection signal in response to the probe signal further comprises:
using a comparator to compare the probe signal to a reference voltage.

24. The method of embodiment 23, wherein the reference voltage has a magnitude between zero point one volts (0. 1V) and zero point five volts (0.5V).

25. The method of embodiment 20, wherein the switching cycle is a power converter switching cycle.

26. The method of embodiment 25, wherein the power converter is a flyback converter.

27. The method of embodiment 20, wherein the magnetic flux probe encloses the time varying magnetic flux of a core.

28. The method of embodiment 27, wherein the core is an energy transfer element core.

29. The method of embodiment 27, wherein the core is an embedded transformer core.

**Claims**

1. A switching power supply comprising:

an energy transfer element comprising a primary winding, a secondary winding, and a core;
a primary switch electrically coupled to the primary winding and configured to generate a magnetic flux within the core according to a switching cycle;
a magnetic flux probe comprising a first resistor and a second resistor, wherein the magnetic flux probe is configured to form a loop enclosing the magnetic flux and to provide a probe signal in proportion to a time derivative of the magnetic flux; and
a synchronous rectifier (SR) electrically coupled to the secondary winding and configured to receive a control signal based, at least in part, upon the probe signal.

2. The switching power supply of claim 1, wherein either:

--the switching power supply is a flyback converter; or
--the energy transfer element is a magnetic component, for example, wherein the magnetic component is an embedded transformer.

3. The switching power supply of claim 1, wherein the magnetic flux probe comprises a first node electrically coupled to the first resistor.

4. The switching power supply of claim 1, wherein the probe signal is determined, at least in part, by an electromotive force (emf) of the first resistor.

5. The switching power supply of claim 1, wherein the probe signal is proportional to a resistance of the first resistor and inversely proportional to a total resistance of the magnetic flux probe, and
optionally wherein the total resistance of the magnetic flux probe comprises the resistance of the first resistor and a resistance of the second resistor.

6. The switching power supply of claim 1, wherein the second resistor is a variable resistor or a trimmable resistor.

7. The switching power supply of claim 1, wherein the magnetic flux probe comprises a first node electrically coupled to the secondary winding, and
optionally wherein the first node is electrically coupled to the synchronous rectifier.

8. The switching power supply of claim 1 further comprising:
a flux detection circuit configured to provide a detection signal in response to the probe signal, wherein the synchronous rectifier is configured to receive a control signal based, at least in part, upon the detection signal.

9. The switching power supply of claim 8, wherein the flux detection circuit comprises a comparator configured to provide the detection signal in response to a comparison of the probe signal to a reference voltage, and
optionally wherein the reference voltage has a magnitude of zero-point one volts (0.1V) to zero-point five volts (0.5V).

10. The switching power supply of claim 1, wherein the magnetic flux probe further comprises:

at least one interconnect electrically coupled between the first resistor and the second resistor, and
optionally wherein the at least one interconnect comprises a printed circuit board trace or a wire.

11. A method of controlling a synchronous rectifier during a switching cycle comprising:

using a magnetic flux probe to measure a time varying magnetic flux;
receiving a probe signal from a first resistor of the magnetic flux probe;
using a flux detection circuit to provide a detection signal in response to the probe signal; and
driving the synchronous rectifier in response to the detection signal.

12. The method of claim 11, further comprising:
adjusting a variable resistor to determine a magnitude of the probe signal.

13. The switching power supply of claim 1 or the method of claim 11, wherein the synchronous rectifier is an N-type field effect transistor (NFET).

14. The method of claim 11, wherein using the flux detection circuit to provide the detection signal in response to the probe signal further comprises:

using a comparator to compare the probe signal to a reference voltage, and
optionally wherein the reference voltage has a magnitude between zero point one volts (0.1V) and zero point five volts (0.5V).

15. The method of claim 11, wherein the switching cycle is a power converter switching cycle, and optionally wherein the power converter is a flyback converter.

16. The method of claim 11, wherein the magnetic flux probe encloses the time varying magnetic flux of a core, and optionally wherein the core is an energy transfer element core or an embedded transformer core.

**FIG. 1A**

FIG. 1B

FIG. 2A

FIG. 2B

**FIG. 2C**

FIG. 2D

FIG. 3A

FIG. 3B

FIG. 4A

FIG. 4B

EP 4 572 114 A1

FIG. 4C

FIG. 4D

EP 4 572 114 A1

500

126

102

102

R1

R2

108

FIG. 5A

500

126

61a

PT_Vcr

PT_RTN

102

61a

R1

108

R2

FIG. 5B

FIG. 5C

FIG. 6A

50

61a

61a

102

R1

R2

+ VR1 -

61b

120

VO

Vref

FIG. 6B

FIG. 7A

**FIG. 7B**

EP 4 572 114 A1

FIG. 8A

FIG. 8B

900

```
┌─────────────────────────────────────────────────────────────┐
│  USE A MAGNETIC FLUX PROBE TO  MEASURE A TIME VARYING        │
│                    MAGNETIC FLUX                             │
└─────────────────────────────────────────────────────────────┘
```
901

```
┌─────────────────────────────────────────────────────────────┐
│  RECEIVE A PROBE SIGNAL FROM A FIRST RESISTOR OF THE         │
│                  MAGNETIC FLUX PROBE                         │
└─────────────────────────────────────────────────────────────┘
```
902

```
┌─────────────────────────────────────────────────────────────┐
│ USE A FLUX DETECTION CIRCUIT TO PROVIDE A DETECTION SIGNAL   │
│           IN RESPONSE TO THE PROBE SIGNAL                    │
└─────────────────────────────────────────────────────────────┘
```
903

```
┌─────────────────────────────────────────────────────────────┐
│  DRIVE THE SYNCHRONOUS RECTIFIER IN RESPONSE TO THE          │
│                   DETECTION SIGNAL                           │
└─────────────────────────────────────────────────────────────┘
```
904

# FIG. 9

Europäisches
Patentamt

European
Patent Office

Office européen
des brevets

# EUROPEAN SEARCH REPORT

**Application Number**

EP 24 21 9076

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 054 066 A1 (TRIDONIC GMBH & CO KG [AT]) 7 September 2022 (2022-09-07) | 1-6,8-16 | INV. H02M3/335 G01R33/02 H02M1/00 |
| Y | * figure 2 * <br> * paragraph [0046] - paragraph [0073] * <br> ----- | 7 | |
| Y | US 2011/149608 A1 (HALBERSTADT HANS [NL]) 23 June 2011 (2011-06-23) | 7 | |
| A | * figures 6-11 * <br> ----- | 1-6,8-16 | |
| A | MICHAEL T ZHANG ET AL: "Design Considerations and Performance Evaluations of Synchronous Rectification in Flyback Converters", IEEE TRANSACTIONS ON POWER ELECTRONICS, INSTITUTE OF ELECTRICAL AND ELECTRONICS ENGINEERS, USA, vol. 13, no. 3, 1 May 1998 (1998-05-01), XP011043184, ISSN: 0885-8993 * figure 1 * * figure 7 * <br> ----- | 1-16 | |

**TECHNICAL FIELDS SEARCHED (IPC)**

H02M
G01R

The present search report has been drawn up for all claims

| Place of search | Date of completion of the search | Examiner |
|---|---|---|
| The Hague | 10 April 2025 | Riehl, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 9076

This annex lists the patent family members relating to the patent documents cited in the above-mentioned European search report.
The members are as contained in the European Patent Office EDP file on
The European Patent Office is in no way liable for these particulars which are merely given for the purpose of information.

10-04-2025

| Patent document cited in search report | | Publication date | Patent family member(s) | | Publication date |
|---|---|---|---|---|---|
| EP 4054066 | A1 | 07-09-2022 | EP | 4054066 A1 | 07-09-2022 |
| | | | EP | 4282065 A1 | 29-11-2023 |
| | | | WO | 2022184527 A1 | 09-09-2022 |
| US 2011149608 | A1 | 23-06-2011 | US | 2011149608 A1 | 23-06-2011 |
| | | | WO | 2010020913 A1 | 25-02-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63610775
- US 95725524